# EUROPEAN PATENT APPLICATION

(11) **EP 0 782 177 A2**
(43) Date of publication of application: **02.07.1997**
(21) Application number: 96120770.1
(22) Date of filing: 23.12.1996
(51) Int. Cl.: H01L 21/00

(54) **Improvements in or relating to semiconductors**

(30) Priority: 28.12.1995 US 19950009522
(71) Applicant: TEXAS INSTRUMENTS INCORPORATED, Dallas Texas 75265 (US); FSI International, Inc., Chaska, MN 55318-1096 (US)
(72) Inventor: FRYSTAK, David C., Frisco, TX 75034 (US); WISE, Rick L., Plano, TX 75025 (US); GROTHE, Phillip A., Eden Prairie, Minnesota 55344 (US); SYVERSON, Daniel J., Chanhassen, Minnesota 55317 (US); BARNETT, Joel M., Austin, Texas 78746 (US)
(74) Representative: Schwepfinger, Karl-Heinz, Dipl.-Ing.

(57) **Abstract**

A method is provided for silicon oxide etching for semiconductor manufacture including rinsing an etched silicon wafer by conducting a stream of deionized liquid water onto a spinning silicon wafer and contacting the deionized water with anhydrous hydrogen fluoride gas, hydrogen chloride gas, ozone, or mixtures thereof.

## Description

### TECHNICAL FIELD OF THE INVENTION

This invention relates in general to the field of semiconductors and more particularly to an improved method for silicon oxide etching which uses anhydrous hydrogen fluoride gas, hydrogen chloride gas, ozone, or mixtures thereof contacted with liquid water as a rinse for trace oxide removal.

### BACKGROUND OF THE INVENTION

Silicon wafers may be used for the production of semiconductors. A silicon wafer may be oxidized to form a silicon dioxide (c) layer on the silicon wafer. Then, all or selective portions of the SiO₂ layer are removed via etching to expose the silicon wafer therebelow. The etching of the SiO₂ may be accomplished by a variety of processes including those which include immersion in an aqueous hydrogen fluoride (HF) acid solution and contacting a wafer with a mixed anhydrous HF gas and water vapor etchant.

Following etching, the manufacturing of the semiconductor is completed by additional processes including processes which add a layer(s) to the etched silicon wafer, such as thin film deposition or growth processes. Interfacial oxide or other contaminants remaining on the exposed silicon portion of the wafer is detrimental to the subsequent thin film deposition or growth process and reduces the quality of the semiconductor produced.

Maintaining a clean ambient environment during the manufacturing of semiconductors is of utmost importance in maintaining the overall quality of the finished product. Problems, including the subsequent formation of oxide on an etched silicon surface and contamination of the wafer, are encountered when the wafer is moved from one piece of manufacturing equipment to another to complete various processing steps, as this may expose the wafer to air or other contaminants.

Following etching, it is often desired to rinse the etched wafer to remove the etchant and by-products of the etching process. Known etch/rinse processes include the immersion of the wafer into a HF acid solution as an etch step, followed by immersion in water as a rinse. These immersion steps necessitate the moving of the wafer from one piece of processing apparatus to a separate processing apparatus, which introduces the possibility of subsequent oxide formation or other contamination of the etched silicon surface.

U.S. Patent No. 5,169,408 to Biggerstaff, et al. discloses a wafer processing apparatus having an etching chamber which provides for a rinsing phase in which deionized water is directed onto the upper surface of a rotating wafer. However, an extended water rinse may cause oxidation at a silicon surface due to several factors, including the deionized water having dissolved oxygen therein, the water thus acting to cause oxidation of the silicon surface, and the water wash may move suspended silicon oxide onto the etched silicon surface. Thus, an extended water rinse is not desired as it may form additional oxide, subsequent to the etching process, on the etched silicon surface. With this discussed process, for a suitable oxide free etched silicon surface, it is required that an otherwise undesired final oxide removal process, such as another etch process, be provided after the rinse.

### SUMMARY OF THE INVENTION

Accordingly, a need has arisen for a silicon oxide etching process which provides for removing trace oxide from the etched silicon surface. Additionally, a need has arisen for a semiconductor manufacturing technique which allows the etching, rinse and subsequent processing steps to be completed in connected processing chambers to avoid moving the wafer from one piece of processing equipment to another which may result in subsequent oxide formation on the etched silicon surface or other contamination of the etched silicon surface. Further, a need has arisen for a cleaner etched silicon surface to provide improved subsequent processing steps, improved production rates, and higher quality semiconductors.

In accordance with the present invention, a method for removing trace oxide from the surface of a silicon wafer is provided that significantly reduces the amount of oxide and other contaminants on the surface of a silicon wafer as compared with known methods. The present invention provides a semiconductor manufacturing technique which allows the etching, rinse and subsequent processing steps, including thin film deposition or growth processes, to be completed in connected or clustered processing modules or chambers to ensure a clean ambient environment is maintained. The removing of trace oxide and other contaminants from the etched silicon surface provides for improved subsequent processing steps, improved production rates, and higher quality semiconductors.

The method includes etching a silicon wafer with a mixture of hydrogen fluoride gas and water vapor. The etched wafer is spun and rinsed by conducting a stream of deionized liquid water onto the spinning wafer and contacting the water with a gas selected from anhydrous hydrogen fluoride gas, hydrogen chloride gas, ozone, and mixtures thereof such that at least some of the gas is absorbed into the water.

### BRIEF DESCRIPTION OF THE DRAWINGS

A more complete understanding of the present invention and the advantages associated therewith may be acquired by referring to the accompanying drawing wherein:

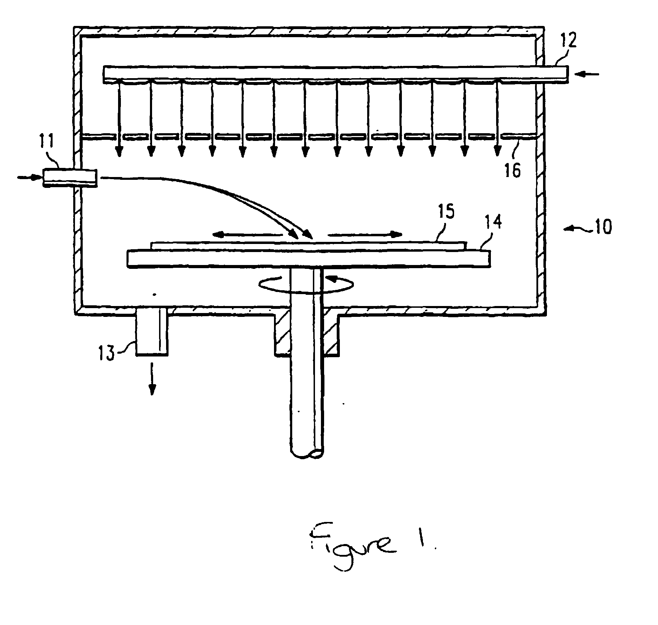

FIGURE 1 is a simplified cross-sectional diagram of a cluster tool compatible module suitable for conducting the inventive method.

### DETAILED DESCRIPTION OF THE INVENTION

In semiconductor manufacturing, various methods are known to etch or otherwise remove silicon oxide and other contaminants from the surface of a silicon wafer. It is desired to provide an etched silicon surface which is free of oxide and other unwanted contaminants. The present invention provides a method for silicon oxide etching which uses a gas selected from anhydrous hydrogen fluoride (HF), hydrogen chloride (HCl), ozone, and mixtures thereof, contacted with liquid water as a rinse to complete the etching process and provide an etched silicon surface which has a significantly reduced level of oxides and other contaminants. This cleaner etched silicon surface provides for improved subsequent processing steps, including a lower temperature epitaxial silicon growth step, and a higher quality semiconductor.

The terms "silicon oxide" and "silicon oxidation", as used herein, refer to oxidation which occurs in any way, intentionally or unintentionally, including thermal oxidation, i.e., heating the wafer in the presence of oxygen, chemical oxidation, i.e., oxidation occurring as a result of a chemical reaction, and native oxide.

The present invention includes an anhydrous HF gas and water vapor etch process, the etching process being completed by a rinsing step which includes conducting a stream of deionized liquid water onto a spinning wafer with anhydrous HF gas, HCl gas, ozone, or mixtures thereof being present and contacting the water, such that the water stream absorbs some of the gas thus becoming an acid solution. This acid solution contacting a horizontally spinning etched silicon surface removes trace oxide and other contaminants present at the etched silicon surface to complete the etching process. This provides a cleaner etched silicon surface, free of oxides and other contaminants, as compared with the known processes for etching.

Also, the present inventive method is particularly applicable for use in cluster tool semiconductor manufacturing equipment. A cluster tool apparatus generally includes a robotic handler located on a platform, with various modules or chambers connected to the platform. The cluster tool equipment is designed for processing single silicon wafers and does not use a wafer carrier in the processing modules. The robotic handler transfers the single silicon wafers between the various modules, with the modules being designed to perform certain processes upon the silicon wafer. The platform has a vacuum loadlock with a nitrogen (N₂) purge, and the modules are connected and sealed to the platform in a way which maintains the clean ambient environment of the equipment. Thus, the silicon wafer can be transferred from one processing step to another within the cluster tool equipment without subjecting the wafer to air, including clean room air, or other environments which could cause oxidation of the silicon surface or introduce other contaminants onto the silicon surface. One such cluster tool equipment supplier is FSI International, Inc. (Chaska, Minn.) which markets a cluster tool apparatus under the trade name EXCALIBUR.

The present inventive method, by providing a cleaner etched silicon surface, also provides for improved subsequent processing steps, and in particular, a lower temperature epitaxial silicon growth process which provides for a faster and lower cost semiconductor manufacture.

FIGURE 1 is a simplified cross-sectional diagram of a cluster tool compatible module 10 suitable for conducting the inventive method. The module 10 includes a deionized water input port 11, an anhydrous HF gas input port 12, and a water removal port 13. The module 10 includes a chuck 14 which spins as indicated and is suitable for holding a silicon wafer 15. The module 10 further includes a distributor 16, such as a membrane, located above the silicon wafer 15, to evenly distribute the anhydrous HF gas within the lower section of the module 10.

In operation, a silicon wafer 15 is placed upon chuck 14 within module 10 and an anhydrous HF gas is introduced through port 12 with introduced water vapor (water vapor port not shown), and the wafer 15 is etched in a way as is known to those of skill in the art. To complete the etching process, a deionized liquid water rinse stream is introduced through water input port 11 and diverted to the upper surface of wafer 15. Simultaneously, a gas selected from the group of anhydrous HF gas, HCl gas, ozone, and mixtures thereof is introduced through port 12. Preferably, anhydrous HF gas is used. Some of the gas is absorbed into the deionized water, forming an acid solution. This acid solution serves to complete the etching process and removes trace oxide and other contaminants from the etched silicon surface of silicon wafer 15. This process also rinses the oxides and other contaminants away from the upper surface of silicon wafer 15.

This rinse step may be controlled to meet the desired results by adjusting the rinse time, the spin rate and/or the water flow rate. Also, nitrogen may be added with the gas as a way of controlling the gas concentration. Further, depending upon the desired results, it may be advantageous to close the anhydrous HF gas port 12 prior to stopping the deionized liquid water flow. This may be advantageously done to sweep away the HF acid solution to quickly stop the etching process. For example, where a layer of thermal oxide has been intentionally formed and a mask is used in the etching process, it may be helpful to quickly stop the etching process so that oxide will not be removed from those places where it is desired to remain. However, any water rinse without anhydrous HF gas being present should be kept as brief as possible to prevent undesired oxidation at the etched silicon surface.

An extended water rinse may cause oxidation at a silicon surface due to several factors, including the deionized water having dissolved oxygen therein, the water thus acting to cause oxidation of the silicon surface, and the water wash may move suspended silicon oxide onto the etched silicon surface. Thus, an extended water rinse is not desired as it may form additional oxide, subsequent to the etching process, on the etched silicon surface.

The following operating parameters have provided a suitably clean etched silicon surface: water flow rate of 450 cc/min directed at the upper and lower surfaces of silicon wafer 15; an anhydrous HF gas flow rate of 500 stand. cc/min (upper), 240 stand. cc/min (lower); the rinse step occurring for 10 seconds with the anhydrous HF gas being supplied for the first 6 seconds with the anhydrous HF gas input port 12 shut off for the last 4 seconds. "Dual side" processing, i.e., cleaning both the upper and lower surfaces, may be desired, as not cleaning the lower surface may detract from the semiconductor's quality due to impurities which may migrate over time within the semiconductor or cause contamination during subsequent processing steps. Other experiments have found that the anhydrous HF gas should flow for the entire rinse processing step.

Upon completion of the rinse processing step, the chuck 14 and silicon wafer 15 are allowed to continue spinning. Since the silicon wafer 15 has a hydrophobic surface, the centrifugal force of the spinning wafer 15 serves to spin off the HF acid solution from the upper surface and sides of the silicon wafer 15. This HF acid solution is removed through exit port 13. Nitrogen may be added to further dry the silicon wafer 15. After the drying step is complete, the cluster tool robotic handler transfers the silicon wafer 15 to another module for subsequent processing steps.

After the etching step is complete, i.e., the silicon wafer 15 is etched, rinsed, and dried, subsequent processing steps, including polysilicon addition, silicon nitride addition, epitaxial silicon growth, metal film deposition, silicon oxidation and/or oxide film deposition, may be performed to complete the semiconductor manufacture.

With known etching processes which leave more oxide and other contaminants, such as carbon and fluorine, at the etched silicon surface than the present inventive method, for epitaxial silicon growth, the previously known processes were required to remove the additional undesired oxide prior to the epitaxial silicon growth. For epitaxial silicon growth with prior etching methods, the silicon wafer was pre-baked in a hydrogen containing atmosphere, such that the hydrogen would react with the oxide at the etched silicon surface to remove the oxide. The pre-bake temperature required to remove sufficient trace oxide prior to the epitaxial silicon growth process was significantly above the required decomposition temperature for epitaxial silicon growth as discussed below. The pre-bake process for trace oxide removal is time and temperature dependent, with a higher temperature requiring a shorter period and a lower temperature requiring a longer period. It had been found that a pre-bake which maintained a temperature of about 900ºC for about 5 minutes or a temperature of about 1200ºC for about 10 seconds provided a suitably clean etched silicon surface for epitaxial silicon growth.

Epitaxial silicon growth generally involves the thermal decomposition of a silicon source gas, typically in a hydrogen ambient, such that a layer of silicon from the source gas grows on the wafer. It is desired that the silicon be deposited in perfect alignment with the underlying wafer, i.e., that the deposited silicon have the same structure and crystal orientation as the underlying wafer. The presence of oxide or other impurities prevents the desired perfect alignment, causing local defects in the crystalline structure which are perpetuated throughout the epitaxial silicon film, resulting in stacking faults or dislocations. The pre-bake step was required with prior etching methods to remove trace oxide and other contaminants to prevent these defects. It has been determined that an undetectable level of oxides measured at the etched silicon surface by secondary ion mass spectroscopy (SIMS) provides a suitably clean etched silicon surface for epitaxial silicon growth.

The silicon source gas may be any suitable gas, including disilane (Si₂H₆) silane (SiH₄), dichlorosilane (SiH₂ Cl₂) trichlorosilane (SiHCl₃) and silicon tetrachlorine (SiCl₄)(gases listed in order of increasing decomposition temperature with disilane having a decomposition temperature of about 850ºC.

With the present inventive method's cleaner etched silicon surface, the epitaxial silicon growth process may occur at a temperature as determined by the decomposition of the silicon source gas, and the high temperature hydrogen pre-bake is not required to remove the undesired oxide. This lower temperature significantly reduces the time required for the epitaxial silicon growth process, and thus, significantly increases semiconductor production rates.

Additionally, the inventive process, by negating the need for the pre-bake process, allows the semiconductor features to be smaller and/or closer together. In semiconductor manufacturing, a thermal budget, i.e., a time-temperature relationship, is set to ensure that doping present does not diffuse from its desired location(s) to an undesired location(s). Thus, eliminating the time and temperature of the pre-bake provides for less diffusion which allows for smaller and/or closer spaced features. The inventive process, by eliminating the pre-bake, provides a desired sharp transition between features produced on a wafer.

### EXAMPLE 1

An experiment was conducted to determine the level of silicon oxide removal at an etched silicon surface comparing the method of the present invention with known methods.

| Silicon Surface* | Percent Oxygen at Avg. |
|---|---|
| Description | S.D. |
| Immersion in an HF solution as the etching step; immersion in water as a rinse; N₂ dry. | 2.7% |
| | 0.8% |
| Anhydrous HF gas and H₂O vapor etch; water rinse while spinning; spin dry. | 6.5% |
| | 0.6% |
| Inventive process -- HF gas and H₂O vapor etch; liquid water contacted with anhydrous HF gas rinse while spinning; spin dry. | 1.4% |
| | 0.6% |

| | |
|---|---|
| * As determined via X-ray photoelectron spectroscopy (XPS). | |

### EXAMPLE 2

An experiment was conducted to determine the effect of clustered versus non-clustered manufacturing techniques upon the oxygen present at a polysilicon/silicon interface.

| Description | Oxygen at Polysilicon/Silicon Interface* | |
|---|---|---|
| | Clustered | Atoms/cm² |
| HF gas and H2O vapor etch; liquid water rinse while spinning; spin dry; polysilicon deposition. | Yes | 1.85E+14 |
| HF gas and H2O vapor etch; liquid water contacted with anhydrous HF gas rinse while spinning; short H2O liquid rinse while spinning; spin dry; polysilicon deposition. | Yes | 8.70E+13 |
| HF aqueous solution immersion etch; immersion water rinse; nitrogen dry; polysilicon deposition. | No | 1.28E+14 |

| | | |
|---|---|---|
| * As determined via secondary ion mass spectroscopy (SIMS). | | |

As can be seen, the method of the present invention utilizing clustered equipment provides the lowest level of oxygen at the polysilicon/silicon interface.

### EXAMPLE 3

An experiment was conducted to determine the level of oxygen and other elements present at the interface of an epitaxial layer of silicon grown on a silicon substrate prepared by the methods shown. The analysis was conducted through the grown silicon epitaxy layer by a technique known by those with skill in the art as secondary ion mass spectroscopy (SIMS). Contaminants, if not removed, reside at the interface between the epitaxial silicon layer and the silicon substrate, and can be quantitatively characterized.

| Description | Oxygen Atoms/cm² | Carbon Atoms/cm² | Fluorine Atoms/cm² |
|---|---|---|---|
| HF aqueous solution etch; immersion water rinse; nitrogen spin dry; epitaxial growth of silicon.* | 5.0E+13 | 1.6E+12 | 2.6E+10 |
| HF gas and H2O vapor etch; liquid water contacted with anhydrous HF gas rinse while spinning; spin dry; epitaxial growth of silicon.* | No Peak | No Peak | No Peak |

| | | | |
|---|---|---|---|
| * No pre-bake; thermal decomposition of dichlorosilane at 850ºC. | | | |

The present inventive method has significant advantages over the prior art. Since the present method may be utilized in a cluster tool apparatus which improves ambient environmental control between processes, it prevents contamination via air, oxygen, water vapor or other contaminants which could cause oxide or contamination at the etched silicon surface. Also, since the spinning wafer 15 spins off the HF acid solution within the module, this improves operator safety by avoiding the risk that HF immersion processes pose to operator safety when used without a final water rinse. Further, the present inventive method is more effective than known HF gas and water vapor etch processes at removing trace oxide from the etched silicon surface prior to thin film deposition or growth processes. Still further, the improved removal of oxide and surface contaminants from the etched silicon surface allows a reduction in the silicon epitaxial growth temperature which results in improved semiconductor production rates. Additionally, elimination of residual oxide from the surface of a conducting film or substrate lowers the contact resistance between such a conducting layer and a conducting film subsequently deposited (on top of it).

Although the present invention has been described in detail, it should be understood that various changes, alterations, and substitutions may be made to the teachings herein without departing from the spirit and scope of the present invention.

## Claims

1. A method of producing a semiconductor device from a silicon wafer having silicon oxide, comprising:
selectively removing at least a portion of the silicon oxide with HF gas and H₂O vapor etching; and
rinsing the etched wafer by conducting a stream of deionized water onto the wafer and contacting the deionized water with a gas selected from the group comprising anhydrous HF gas, HCl gas, ozone, and mixtures thereof to absorb at least some of the gas into the deionized water.

2. The method of Claim 1, wherein the rinsing step comprises conducting the stream of water onto a spinning wafer.

3. The method of Claim 2, wherein the step of spinning the wafer comprises spinning the wafer in a horizontal plane.

4. The method of any preceding claim, further comprising the step of:
following rinsing, continuing spinning the wafer to remove, by centrifugal force, at least some of the water with absorbed gas.

5. The method of any preceding claim, further comprising the step of:
contacting the rinsed etched wafer with nitrogen gas to dry the wafer.

6. The method of any preceding claim, further comprising the step of:
further processing the rinsed etched wafer by a process selected from the group comprising polysilicon addition, silicon nitride addition, epitaxial silicon growth, metal film deposition, silicon oxidation and oxide film deposition.

7. The method of any preceding claim, further comprising the steps of:
contacting the rinsed etched wafer with a silicon source gas; and
heating the silicon source gas to a temperature of not more than about the thermal decomposition temperature of the source gas to cause epitaxial silicon growth on the wafer.

8. The method of any preceding claim, further comprising performing the steps of HF gas and H₂O vapor etching and rinsing within a cluster tool compatible module, and
transferring the rinsed etched wafer to at least one additional cluster tool compatible module for further processing, the cluster tool providing a clean ambient environment for the wafer during the transferring step.

9. The method of any preceding claim, further comprising performing the rinsing step with an anhydrous HF gas.

10. A semiconductor produced by a process comprising:
selectively removing at least a portion of silicon oxide from a silicon wafer with HF gas and H₂O vapor etching; and
rinsing the etched wafer by conducting a stream of deionized water onto the wafer and contacting the deionized water with a gas selected from the group comprising anhydrous HF gas, HCl gas, ozone, and mixtures thereof to absorb at least some of the gas into the deionized water.

11. The semiconductor of Claim 10, wherein the rinsing step comprises conducting the stream of water onto a spinning wafer.

12. The semiconductor of Claim 11, wherein the step of spinning the wafer comprises spinning the wafer in a horizontal plane.

13. The semiconductor of any of Claim 10 to 12, wherein the process further comprises the step of:
following rinsing, spinning the wafer to remove, by centrifugal force, at least some of the water with absorbed gas.

14. The semiconductor of any of Claims 10 to 13, wherein the process further comprises the step of:
contacting the rinsed etched wafer with nitrogen gas to dry the wafer.

15. The semiconductor of any of Claims 10 to 14, wherein the process further comprises the step of:
further processing the rinsed etched wafer by a process selected from the group comprising polysilicon addition, silicon nitride addition, epitaxial silicon growth, metal film deposition, silicon oxidation, and oxide film deposition.

16. The semiconductor of any of Claims 10 to 15, wherein the process further comprises the steps of:
contacting the rinsed etched wafer with a silicon source gas; and
heating the silicon source gas to a temperature of not more than about the thermal decomposition temperature of the source gas to cause epitaxial silicon growth on the wafer.

17. The semiconductor of any of Claims 10 to 16, further comprising performing the steps of HF gas and H₂O vapor etching and rinsing within a cluster tool compatible module, and
transferring the rinsed etched wafer to at least one additional cluster tool compatible module for further processing, the cluster tool providing a clean ambient environment for the wafer during the transferring step.

18. The semiconductor of any of Claim 10, further comprising performing the rinsing step with an anhydrous HF gas.

19. A method of producing a semiconductor from a silicon wafer having silicon oxide on an exterior surface thereof, comprising the steps of:
etching the silicon wafer with a mixture comprising HF gas and H₂O vapor to produce an etched silicon surface; and
spinning the wafer; and
removing trace oxide from the etched silicon surface by conducting a stream of deionized water onto the spinning wafer and contacting the deionized water with anhydrous HF gas to absorb at least some of the HF gas into the deionized water.

20. The method of Claim 19, further comprising removing the trace oxide to an undetectable level as measured by secondary ion mass spectroscopy.

21. The method of Claim 19 or Claim 20, further comprising the steps of:
contacting the etched wafer with a silicon source gas; and
heating the silicon source gas to a temperature of not more than about the thermal decomposition temperature of the source gas to cause epitaxial silicon growth on the wafer.

22. The method of any of Claims 19 to 21, further comprising performing the etching and removing trace oxide steps are conducted within a cluster tool compatible module, and
transferring the etched silicon wafer after removing trace oxide to at least one additional cluster tool compatible module for further processing, the cluster tool providing a clean ambient environment for the wafer during the transferring step.
